# FASCICULE DE BREVET EUROPEEN

(11) **EP 0 578 580 B1**
(45) Date de publication et mention de la délivrance du brevet: **12.02.1997**
(21) Numéro de dépôt: 93401793.0
(22) Date de dépôt: 08.07.1993
(51) Int. Cl.: H01J 37/32, H05H 1/46

(54) **Dispositif pour le dépôt de polymère par l'intermédiaire d'un plasma excité par micro-ondes**
Anordnung zur Polymer-Beschichtung mittels einen durch Mikrowellen angeregten Plasma
Device for coating polymer with a microwave excited plasma

(30) Priorité: 08.07.1992 FR 9208447
(43) Date de publication de la demande: 12.01.1994
(73) Titulaire: VALEO VISION, 93000 Bobigny (FR)
(72) Inventeur: Montalan, Dominique, F-75019 Paris (FR); Phan, Pascal, F-95000 Cergy (FR); Renoult, Jean-Pierre, F-75020 Paris (FR); Rolland, Pascal, F-78150 Roquencourt (FR)
(74) Mandataire: Martin, Jean-Jacques

(56) Documents cités:
- EP-A- 0 380 119
- EP-A- 0 382 065
- WO-A-91/12353
- PATENT ABSTRACTS OF JAPAN, vol. 14, no. 380 (E-965) 16 Août 1990 & JP-A-02 138 735

## Description

La présente invention concerne un dispositif pour le dépôt de polymère sous vide en phase vapeur par l'intermédiaire d'un plasma excité par micro-ondes sur des surfaces d'une pluralité d'éléments, notamment des surfaces intérieures aluminées de réflecteurs de projecteurs de véhicules.

L'invention concerne également un procédé de réalisation d'un tel dépôt.

L'invention trouve une application particulièrement avantageuse notamment dans le domaine de l'équipement de véhicules pour la réalisation d'une couche de protection sur des surfaces aluminées très incurvées d'éléments tels que des réflecteurs de projecteurs d'automobiles.

Actuellement, on connaît de l'état de la technique par WO-A-9 112 353 un dispositif pour la réalisation du dépôt précité, comportant une enceinte de dépôt dans laquelle sont placés lesdits éléments, des moyens pour établir un vide poussé dans ladite enceinte, des moyens d'excitation par micro-ondes comprenant un générateur de micro-ondes et au moins un applicateur de micro-ondes se terminant par une antenne prévue dans l'enceinte et recevant les micro-ondes par l'intermédiaire d'au moins une fenêtre étanche au gaz et transparente vis-à-vis des micro-ondes, et au moins un diffuseur de gaz monomère disposé à l'intérieur de l'enceinte de dépôt à proximité de l'antenne.

Ainsi, on injecte à l'intérieur de l'enceinte par l'intermédiaire du diffuseur, un gaz monomère tel que l'hexaméthyldisiloxane et on y applique des micro-ondes afin de créer un plasma excité par micro-ondes dans lequel les monomères se radicalisent, les espèces ainsi formées venant se déposer entre autres sur les surfaces intérieures aluminées desdits éléments exposés au plasma excité, pour se recombiner sous forme de film.

Ce dispositif connu présente un certain nombre d'inconvénients.

Tout d'abord, la conception du ou de chaque applicateur doit être faite en fonction d'un certain nombre de paramètres tels que la forme et la taille de l'enceinte et, dans le cas où plusieurs applicateurs doivent être prévus, on assiste à des couplages indésirables entre ceux-ci, qui rendent cette conception encore plus délicate. Au surplus, les éléments à revêtir disposés à l'intérieur de l'enceinte influencent l'excitation par micro-ondes, ce qui pose des problèmes lorsque le réacteur doit être utilisé pour plusieurs types d'éléments.

Ensuite, on observe classiquement que le polymère se dépose progressivement sur la fenêtre de passage des micro-ondes, et peut se détacher de celle-ci de façon aléatoire. Ainsi, dans le cas où des éléments à revêtir sont situés à l'aplomb de la fenêtre, ceci peut conduire à une détérioration des éléments en cours de dépôt situés dans l'enceinte.

On connaît en outre, du document EP - 382 065, un dispositif de traitement à plasma avec des moyens d'application des micro-ondes dans une enceinte, lesdits moyens d'application comportant une cavité résonnante munie d'une paroi plane tournée vers la fenêtre de l'enceinte, cette paroi comprenant une pluralité de fentes rayonnantes disposées en cercle et formant antenne de rayonnement des micro-ondes.

La présente invention vise à pallier ces inconvénients de la technique antérieure tout en permettant de créer un plasma extrêmement homogène et peu sensible l'environnement, et donc un dépôt uniforme de polymère sur les éléments.

Elle propose à cet effet un dispositif tel que défini dans la revendication 1.

Des aspects préférés du dispositif sont exposés dans les sous-revendications.

L'invention propose également un procédé faisant appel à un tel dispositif.

D'autres aspects, buts et avantages de la présente invention apparaîtront mieux à la lecture de la description détaillée suivante d'une forme de réalisation préférée de celle-ci, donnée à titre d'exemple et faite en référence aux dessins annexés, sur lesquels :
La figure 1 est un schéma-bloc d'ensemble d'un réacteur pour dépôt de polymère équipé d'un générateur de micro-ondes et d'un applicateur de micro-ondes selon l'invention,
la figure 2 est une vue plus détaillée en élévation de côté et en coupe partielle de l'enceinte de réaction et de l'applicateur de micro-ondes,
la figure 3 est une vue en bout, en coupe partielle et à échelle agrandie, de l'applicateur de micro-ondés selon l'invention,
la figure 4 est une vue en élévation de côté de l'applicateur de micro-ondes de la figure 3,
la figure 5 est une vue de dessous d'un guide à fentes rayonnantes utilisé dans l'applicateur des figures 3 et 4, et
la figure 6 est une vue en élévation de côté du guide à fentes rayonnantes de la figure 5.

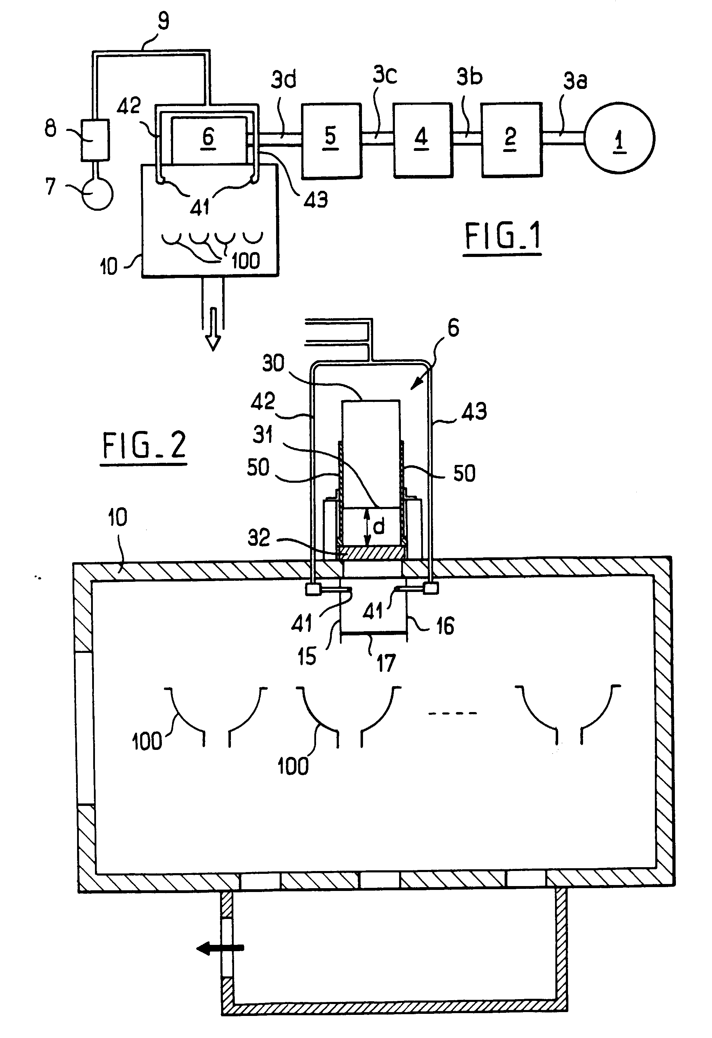

En référence tout d'abord à la figure 1, on a représenté un réacteur pour le dépôt de polymère sous vide en phase vapeur par l'intermédiaire d'un plasma excité par micro-ondes sur des surfaces d'une pluralité d'éléments, notamment des surfaces intérieures aluminées de réflecteurs de projecteurs de véhicules.

Ce dépôt de polymère constitue un film transparent de protection desdites surfaces aluminées.

Le réacteur comprend les éléments principaux suivants :
- un générateur de micro-ondes 1;
- un circulateur 2 couplé au générateur 1 par un premier guide d'ondes 3a;
- facultativement, un dispositif 4 de mesure des puissances de micro-ondes incidentes et réfléchies, couplé au circulateur 2 par un deuxième guide d'ondes 3b;
- un dispositif d'accord de ligne 5 couplé au dispositif de mesure 4 par un troisième guide d'ondes 3c;
- un excitateur de plasma 6 ou applicateur de micro-ondes couplé au dispositif d'accord de ligne 5 par un quatrième guide d'ondes 3d; cet excitateur est couplé à une enceinte 10 dans laquelle un vide poussé est établi à l'aide d'une pompe à vide (non représentée).

Dans l'enceinte 10 sont disposés les réflecteurs 100 sur la surface intérieure desquels le dépôt doit être effectué.

La référence 7 désigne un réservoir de monomères dont la sortie est reliée à un débit-mètre massique 8 destiné à réguler la quantité de monomères à introduire dans l'enceinte 10. En 9 est indiquée une ligne de transport des gaz monomères, qui se dédouble au voisinage de l'enceinte en deux conduits 42, 43 aboutissant respectivement à deux dispositifs diffuseurs 41 situés dans l'enceinte 10 de part de d'autre d'une fenêtre de sortie de l'excitateur 6.

L'applicateur 6 de micro-ondes débouche dans l'enceinte 10 par l'intermédiaire d'une fenêtre 32 étanche au gaz et transparente vis-à-vis des micro-ondes. La fenêtre 32 est par exemple une plaque de Pyrex (marque déposée) ou de quartz.

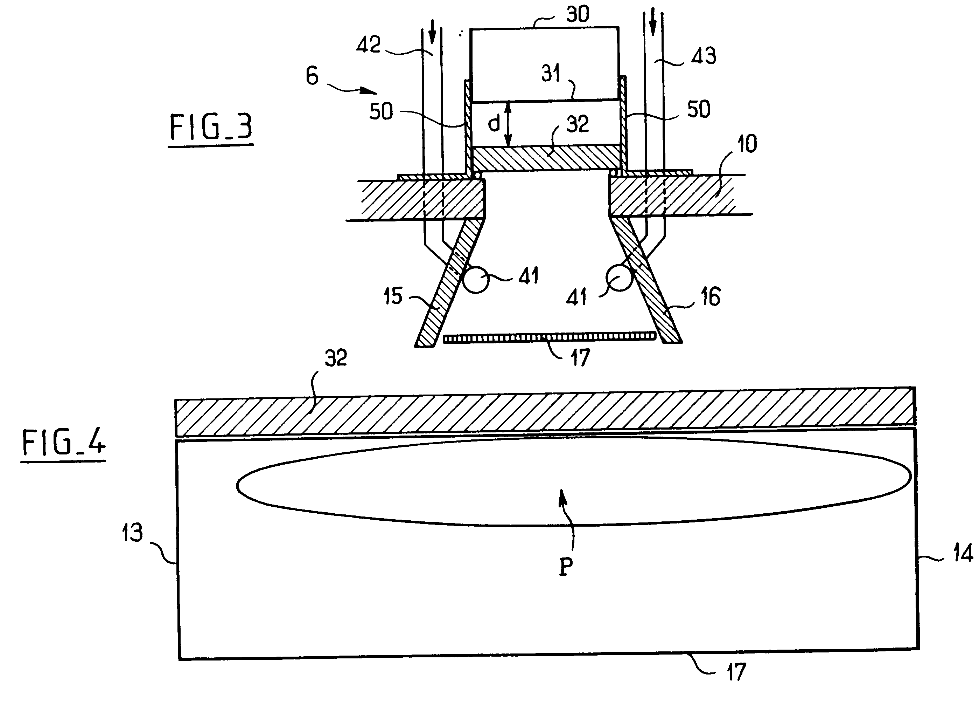

On va maintenant décrire en référence aux figures 2 à 6 la structure de l'applicateur 6 de micro-ondes réalisé selon l'invention.

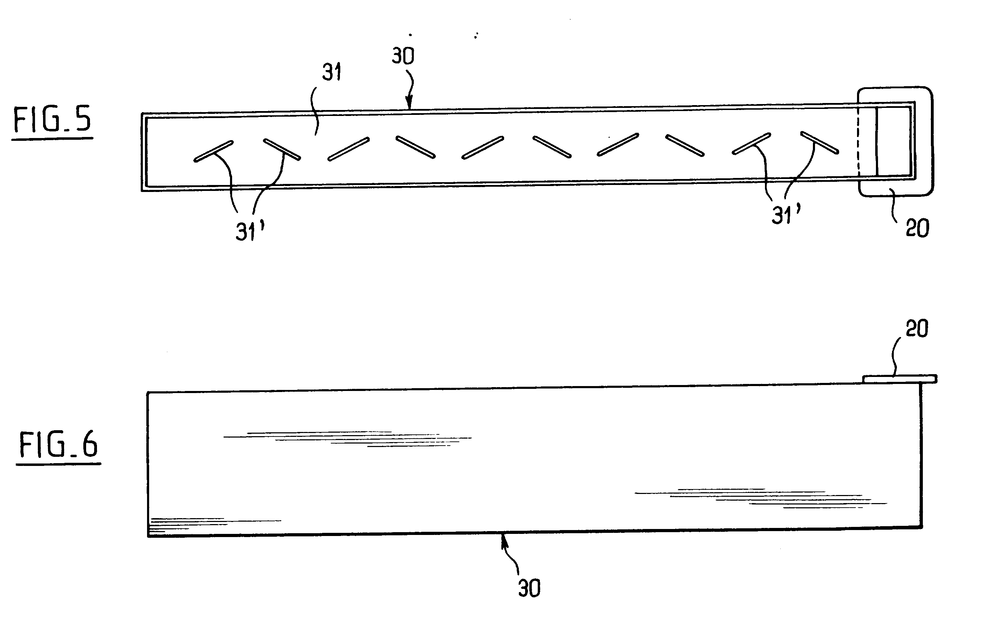

L'applicateur comprend une première partie située à l'extérieur de l'enceinte 10 et exposée à la pression atmosphérique. Cette première partie comprend, pour appliquer les micro-ondes au gaz monomère injecté dans l'enceinte, un guide à fentes rayonnantes 30 représenté en détail sur les figures 5 et 6.

Le guide 30 est destiné à transférer les ondes qui lui sont appliquées via le guide d'ondes 3d (au niveau d'une ouverture 20) à l'espace intérieur de l'enceinte 10, et est constitué par un corps creux de forme généralement parallélépipédique dont la paroi inférieure est constituée par une plaque 31 dans laquelle sont formées une pluralité de fentes 31', disposées par exemple comme représenté sur la figure 5.

Le guide 30 est disposé au-dessus d'une fenêtre pour micro-ondes réalisée sous la forme d'une plaque 32 transparente aux micro-ondes, par exemple en Pyrex (Marque déposée) ou en quartz, reliée aux parois avoisinantes de l'enceinte 10 de façon étanche.

Selon une caractéristique de l'invention, le guide 30 à fentes rayonnantes permet d'éviter le recours à une cavité de micro-ondes à l'intérieur de l'enceinte, en créant en amont de la fenêtre 32 un mode d'ondes unique, propice à l'obtention d'un plasma homogène.

Une armature métallique 50 entoure l'ensemble constitué du guide 30 et de la plaque 32 pour maintenir ces éléments et minimiser les fuites de micro-ondes.

La deuxième partie de l'applicateur 6 est située à l'intérieur de l'enceinte 10 et est exposée au vide régnant dans celle-ci. Elle comprend une pluralité de volets 13-16 qui sont montés articulés sur la paroi supérieure de l'enceinte de manière à pouvoir faire varier leur inclinaison.

Ces volets 13-16 sont en l'espèce au nombre de quatre et disposés le long des quatre côtés de la plaque 32, elle-même rectangulaire. Ils sont métalliques et peuvent être pleins ou ajourés, par exemple grillagés.

A l'extrémité libre des volets 13-16 est prévu un élément métallique 17 formant court-circuit. Cet élément est plan dans le présent exemple, mais pourrait également adopter une forme galbée ou bombée.

De même que les volets, l'élément 17 est plein ou ajouré. Dans le cas où aussi bien les volets 13-16 que l'élément 17 sont pleins, on prévoit entre eux des interstices suffisants pour permettre aux radicaux issus du gaz monomère d'atteindre le reste de l'enceinte et de se combiner sur les surfaces de réflecteurs à revêtir.

L'ensemble constitué des volets 13-16 et de l'élément inférieur 17 constitue une sorte de panier métallique, avec les avantages expliqués plus loin. Les diffuseurs 41 sont disposés à l'intérieur de ce panier.

De façon préférée, la distance d entre le guide à fentes 30 et la plaque 32 est réglable, par exemple entre zéro et une fois la longueur d'onde des micro-ondes générées. Les moyens mécaniques pour effectuer un tel réglage peuvent être de tout type approprié et ne seront pas décrits. Des essais effectués par la Demanderesse ont permis de constater des résultats satisfaisants en fixant d à environ une demi-longueur d'onde.

Le réacteur équipé du générateur de micro-ondes et de l'applicateur selon l'invention fonctionne de la façon suivante : en appliquant des micro-ondes d'une énergie bien contrôlée dans la structure de panier précitée, et en injectant dans ce dernier le gaz monomère, on crée dans l'espace confiné défini par ledit panier un plasma P excité à partir dudit gaz monomère. Les monomères radicalisés par les micro-ondes se répartissent dans l'enceinte 10 et viennent se recombiner sur les surfaces à revêtir pour former un dépôt de polymère.

Les avantages de la structure d'applicateur selon l'invention sont nombreux.

Tout d'abord, le panier 13-17 permet de contrôler l'étendue et l'intensité du plasma et de rendre ce plasma insensible à la présence d'objets situés dans l'enceinte 10 à l'extérieur du panier. En outre, dans le cas où une même enceinte est équipée d'une pluralité d'applicateurs tels que décrits, on assure un découplage entre ces applicateurs.

Plus précisément, le panier métallique joue le rôle d'un piège à ondes. Une conséquence de ceci est qu'un générateur de plasma selon l'invention peut être facilement implanté sur des réacteurs de constructions et de types divers.

En outre, dans un réacteur tel que décrit, il peut arriver que les radicaux forment un dépôt sur la plaque 32 elle-même. A mesure qu'un tel dépôt voit son épaisseur croître, on assiste à la séparation de ce dépôt par gravité, des débris de polymère tombant ainsi dans l'enceinte et venant contaminer les pièces à traiter. Avec la présente invention, le panier entourant le plasma, et notament l'élément inférieur 17, permet de bloquer cette chûte de débris et d'éviter toute contamination des pièces traitées.

Enfin, la structure métallique du panier constituant une cavité électromagnétique, celle-ci peut être utilisée si nécessaire, en choisissant ses dimensions de façon appropriée, pour favoriser l'amorçage du plasma à la mise en route du réacteur.

On va maintenant indiquer un certain nombre de paramètres préférés pour la mise en oeuvre pratique de la présente invention:
- fréquence des micro-ondes générées : 2,45 GHz;
- distance entre guide 30 et plaque 32 : entre zéro et une fois la longueur d'onde des micro-ondes;
- longueur du panier: entre une demi et une longueur d'onde, soit environ 65 à 130 cm pour la fréquence considérée;
- nature du gaz de dépôt : famille des silanes et des siloxanes, et plus particulièrement l'hexaméthyldisiloxane, seuls ou en mélange avec des gaz soit atomiques (notamment l'argon), soit moléculaires (notamment l'oxygène ou l'azote); les gaz de la famille des alcanes, des alcynes et des alcènes peuvent également être utilisés.
- vide dans l'enceinte 10 : entre 0,5 et 50 Pa, de préférence entre 1 et 20 Pa;
- puissance des micro-ondes : de 20 à 500 watts par fente;
- dimensions de la plaque 31 du guide 30 : 99 cm x 18 cm.

On observera ici que la longueur et la disposition des fentes 31' sont déterminées en fonction notamment de la longueur d'onde des micro-ondes et de la puissance à rayonner. La longueur et la disposition telles que représentées sur la figure 5 sont à considérer comme incluses dans la présente description. La largeur des fentes a toutefois été exagérée sur cette figure par souci de clarté.

Bien entendu, selon la taille et la géométrie de l'enceinte de réaction, on équipera celle-ci de tout nombre approprié d'applicateurs à guide selon la présente invention.

## Revendications

1. Dispositif pour le dépôt de polymère sous vide en phase vapeur par l'intermédiaire d'un plasma excité par micro-ondes sur des surfaces d'une pluralité d'éléments (100) notamment des surfaces intérieures aluminées de réflecteurs de projecteurs de véhicules automobiles, comportant d'une part une enceinte de dépôt (10) dans laquelle sont placés lesdits éléments (100), des moyens pour établir un vide poussé dans ladite enceinte (10), des moyens d'excitation à micro-ondes comprenant un générateur de micro-ondes (20), un guide d'ondes (30) situé à l'extérieur de l'enceinte (10), pourvu d'une ouverture d'entrée des micro-ondes et apte à transférer les ondes à l'espace intérieur de l'enceinte via au moins une fenêtre (32) étanche au gaz et transparente vis-à-vis des micro-ondes, et au moins un diffuseur de gaz monomère (40) disposé à l'intérieur de l'enceinte (10) de dépôt à proximité de chaque fenêtre (32), dispositif caractérisé en ce que ledit guide d'ondes (30) comprend une paroi (31) généralement plane, tournée vers ladite fenêtre, comportant une pluralité de fentes rayonnantes (31') disposées selon deux directions obliques par rapport à une direction longitudinale du guide d'ondes (30), et formant moyens d'application des micro-ondes dans l'enceinte.

2. Dispositif selon la revendication 1, caractérisé en ce que la distance (d) entre la paroi (31) du guide d'ondes comportant les fentes et la fenêtre (32) est réglable.

3. Dispositif selon la revendication 2, caractérisé en ce que ladite distance (d) est réglable entre environ zéro et une fois la longueur d'onde des micro-ondes.

4. Dispositif selon l'une des revendications 1 à 3, caractérisé en ce qu'il comprend au droit de la ou chaque fenêtre, à l'intérieur de l'enceinte (10), une structure métallique ouverte (13-17) dans laquelle s'étend le diffuseur au moins prévu et définissant un espace de confinement du plasma tout en autorisant la répartition du gaz monomère excité dans l'enceinte.

5. Dispositif selon la revendication 4, caractérisé en ce que ladite structure métallique est constituée par des volets latéraux (13-16) bordant la fenêtre et par une plaque (17) s'étendant à distance de ladite fenêtre entre les volets et formant court-circuit.

6. Dispositif selon la revendication 5, caractérisé en ce que lesdits volets (13-16) sont articulés sur une paroi de l'enceinte (10) à proximité de ladite fenêtre (32).

7. Dispositif selon l'une des revendications 4 à 6, caractérisé en ce que le guide d'onde à fentes rayonnantes (31'), la fenêtre (32) et la structure métallique de confinement (13-17) sont de forme allongée, avec une grande dimension dont l'ordre de grandeur est celui de la longueur d'onde des micro-ondes et avec une petite dimension dont l'ordre de grandeur est une fraction de ladite longueur d'onde.

8. Procédé de dépôt de polymère sous vide en phase vapeur par l'intermédiaire d'un plasma excité par micro-ondes sur des surfaces d'une pluralité d'éléments (100) notamment des surfaces intérieures aluminées de réflecteurs de projecteurs de véhicules, caractérisé en ce qu'il est mis en oeuvre avec un dispositif selon l'une des revendications 1 à 7.

## Patentansprüche

1. Vorrichtung zur Aufbringung eines Polymerauftrags durch Vakuumbeschichtung aus der Gasphase mittels eines durch Mikrowellen erregten Plasmas auf Oberflächen einer Mehrzahl von Elementen (100), insbesondere auf aluminierten Innenflächen der Reflektoren von Fahrzeugscheinwerfern, bestehend aus einer Auftragskammer (10), in der die besagten Elemente (100) angeordnet werden, Mitteln zur Erzeugung eines Hochvakuums in der besagten Kammer (10), Mikrowellen-Erregungsmitteln, die einen Mikrowellengenerator (20), und einen außerhalb der Auftragskammer (10) angeordneten Hohlleiter (30) mit einer Eintrittsöffnung für die Mikrowellen zur Zuführung der Mikrowellen in den Innenraum der Auftragskammer über wenigstens ein gasdichtes und für die Mikrowellen durchlässiges Fenster (32) umfassen, und aus wenigstens einem Monomergas-Diffusor (40), der im Innern der Auftragskammer (10) in der Nähe jedes Fensters (32) angeordnet ist, **dadurch gekennzeichnet**, daß der besagte Hohlleiter (30) eine zu dem besagten Fenster gerichtete allgemein ebenen Wand (31) umfaßt, die eine Mehrzahl von Schlitzstrahlern (31') enthält, die in zwei, im Verhältnis zu einer Längsrichtung des Hohlleiters (30) schräg verlaufenden Richtungen angeordnet sind und die Mittel für die Zuführung der Mikrowellen in die Auftragskammer bilden.

2. Vorrichtung nach Anspruch 1 , **dadurch gekennzeichnet**, daß der Abstand (d) zwischen der Wand (31) des Hohlleiters mit den Schlitzen und dem Fenster (32) einstellbar ist.

3. Vorrichtung nach Anspruch 2 , **dadurch gekennzeichnet**, daß der besagte Abstand (d) zwischen etwa Null und der einfachen Wellenlänge der Mikrowellen einstellbar ist.

4. Vorrichtung nach einem der Ansprüche 1 bis 3, **dadurch gekennzeichnet**, daß sie in Höhe des bzw. jedes Fensters im Innern der Auftragskammer (10) eine offene Metallstruktur (13-17) umfaßt, in der sich der Diffusor, der wenigstens vorgesehen ist, erstreckt und die einen Raum für die Einschließung des Plasmas bildet, wobei sie gleichzeitig die Verteilung des erregten Monomergases in der Auftragskammer ermöglicht.

5. Vorrichtung nach Anspruch 4 , **dadurch gekennzeichnet**, daß die besagte Metallstruktur aus seitlichen Klappen (13-16), die das Fenster einfassen, und aus einer Platte (17) besteht, die sich in einem Abstand von dem besagten Fenster zwischen den Klappen erstreckt und einen Kurzschluß bildet.

6. Vorrichtung nach Anspruch 5 , **dadurch gekennzeichnet**, daß die besagten Klappen (13-16) schwenkbar an einer Wand der Auftragskammer (10) in der Nähe des besagten Fensters (32) angebracht sind.

7. Vorrichtung nach einem der Ansprüche 4 bis 6,**dadurch gekennzeichnet**, daß der Schlitzstrahler-Hohlleiter (31'), das Fenster (32) und die Einschließungsstruktur aus Metall (13-17) eine längliche Form aufweisen, mit einer großen Abmessung, deren Größenordnung derjenigen der Wellenlänge der Mikrowellen entspricht, und einer kleinen Abmessung, deren Größenordnung einem Bruchteil der besagten Wellenlänge entspricht.

8. Verfahren zur Aufbringung eines Polymerauftrags durch Vakuumbeschichtung aus der Gasphase mittels eines durch Mikrowellen erregten Plasmas auf Oberflächen einer Mehrzahl von Elementen (100), insbesondere auf aluminierten Innenflächen der Reflektoren von Fahrzeugscheinwerfern , **dadurch gekennzeichnet**, daß seine Anwendung mit einer Vorrichtung nach einem der Ansprüche 1 bis 7 erfolgt.

## Claims

1. Device for the vapour deposition of polymer under vacuum by means of a plasma excited by microwaves on surfaces of a plurality of elements (100), notably aluminised intemal surfaces of motor vehicle headlamp reflectors, having on the one hand a deposition chamber (10) in which the said elements (100) are placed, means for establishing a high vacuum in the said chamber (10), microwave excitation means comprising a microwave generator (20), a waveguide (30) situated outside the chamber (10), provided with an entry opening for the microwaves and suitable for transferring the waves to the internal space of the chamber via at least one aperture (32) impervious to gas and transparent vis-a-vis microwaves, and at least one monomer gas diffuser (40) disposed inside the deposition chamber (10) in the vicinity of each aperture (32), a device characterised in that the said waveguide (30) comprises a roughly plane wall (31) turned towards the said aperture, having a plurality of radiating slots (31') disposed in two directions oblique with respect to a longitudinal direction of the waveguide (30), and forming means of applying the microwaves in the chamber.

2. Device according to Claim 1, characterised in that the distance (d) between the wall (31) of the waveguide including the slots and the aperture (32) is adjustable.

3. Device according to Claim 2, characterised in that the said distance (d) is adjustable between approximately 0 and a distance equal to the wavelength of the microwaves.

4. Device according to one of Claims 1 to 3, characterised in that it comprises, in line with the aperture or apertures, inside the chamber (10), an open metallic structure (13-17) in which the diffuser at least provided extends, defining a containment space for the plasma whilst allowing the distribution of the excited monomer gas in the chamber.

5. Device according to Claim 4, characterised in that the said metallic structure consists of lateral shutters (13-16) bordering the aperture and a plate (17) extending at a distance from the said aperture between the shutters and forming a short-circuit.

6. Device according to Claim 5, characterised in that the said shutters (13-16) are hinged on a wall of the chamber (10) in the vicinity of the said aperture (32).

7. Device according to one of Claims 4 to 6, characterised in that the waveguide with radiating slots (31'), the aperture (32) and the metallic containment structure (13-17) are of elongate shape, with a large dimension whose order of magnitude is that of the wavelength of the microwaves and with a small dimension whose order of magnitude is a fraction of the said wavelength.

8. Process for the vapour deposition of polymer under vacuum by means of a plasma excited by microwaves on surfaces of a plurality of elements (100), notably aluminised internal surfaces of vehicle headlamp reflectors, characterised in that it is implemented with a device according to one of Claims 1 to 7.
